# EUROPÄISCHE PATENTSCHRIFT

(11) **EP 2 695 196 B1**
(45) Veröffentlichungstag und Bekanntmachung des Hinweises auf die Patenterteilung: **27.07.2022**
(21) Anmeldenummer: 12729338.9
(22) Anmeldetag: 29.03.2012
(51) Int. Cl.: H01L 29/80, B82Y 10/00, G11C 16/04, H01L 29/788

(54) **SPEICHERZELLE**
MEMORY CELL
CELLULE DE MÉMOIRE

(30) Priorität: 05.04.2011 DE 102011006782
(43) Veröffentlichungstag der Anmeldung: 12.02.2014
(73) Patentinhaber: Technische Universität Berlin, 10623 Berlin (DE)
(72) Erfinder: MARENT, Andreas, 10965 Berlin (DE); BIMBERG, Dieter, 14089 Berlin (DE)
(74) Vertreter: Fischer, Uwe
(86) Internationale Anmeldenummer: PCT/DE2012/200019
(87) Internationale Veröffentlichungsnummer: WO 2012/136206

(56) Entgegenhaltungen:
- EP-A1- 1 523 012
- DE-A1-102006 059 110
- US-A- 4 103 312
- US-A- 5 923 046
- US-A1- 2009 213 662
- US-B1- 6 720 589
- M. GELLER; A. MARENT; T. NOWOZIN; D. BIMBERG; N. AKCAY; N. ONCAN: "A write time of 6 ns for quantum dot-based memory structures", APPL. PHYS. LETT., Bd. 92, Nr. 9, 2008, Seite 092108, XP12108480, in der Anmeldung erwähnt
- GELLER M ET AL: "Tunneling emission from self-organized In(Ga)As/GaAs quantum dots observed via time-resolved capacitance measurements", PHYSICAL REVIEW, B. CONDENSED MATTER, AMERICAN INSTITUTE OF PHYSICS. NEW YORK, US, Bd. 73, Nr. 20, 15. Mai 2006 (2006-05-15), Seiten 205331-1, XP002480344, ISSN: 0163-1829, DOI: 10.1103/PHYSREVB.73.205331

## Beschreibung

Die Erfindung bezieht sich auf ein Verfahren zum Speichern einer Bitinformation in einem binären Speicherbereich einer Speicherzelle.

Die kommerziell wichtigsten Halbleiterspeicher sind heutzutage "flüchtige" DRAM-Speicher und "nichtflüchtige" Flash-Speicher [1] [2] [3] .

DRAM-Speicher, die beispielsweise als Arbeitsspeicher in Personal-Computern zur Anwendung kommen, speichern Informationen als Ladung in einem Kondensator. Die Vorteile des DRAM-Speichers liegen in einer schnellen Zugriffszeit im Bereich von unter 10 Nanosekunden und einer hohen Haltbarkeit von >10¹⁶ Schreib- und Löschzyklen. Der entscheidende Nachteil ist eine kurze Speicherzeit von wenigen zehn Millisekunden. Die Schreib- und Löschspannung beträgt ca. 2,5 V.

Beim Flash-Speicher, der z. B. in Memory-Sticks, Digitalkameras oder Handys eingesetzt wird, kommt eine MOSFET-Struktur mit einem sogenannten "Floating-Gate" als Speicherelement zum Einsatz. Durch Verwendung von SiO₂-Barrieren, innerhalb derer die Ladung gespeichert wird, ist der Flash-Speicher in der Lage, Speicherzeiten von mehr als 10 Jahren zu erreichen. Der Nachteil der SiO₂-Barrieren besteht in einer sehr langsamen Schreibzeit in der Größenordnung von Mikrosekunden und einer geringen Haltbarkeit von nur rund einer Million Lösch- und Schreibzyklen. Darüber hinaus liegen die Schreib- bzw. Löschspannungen bei mehr als 12 V, was zu einer hohen Energieaufnahme der Speicherzelle führt. Der Schreibprozess beim Flash-Speicher erfolgt mittels Injektion "heißer" Ladungsträger, die durch Anlegen einer hohen Spannung über eine der beiden SiO₂-Barrieren in das "Floating-Gate" gebracht werden. Die heißen Ladungsträger zerstören jedoch wegen ihrer hohen kinetischen Energie peu à peu die Barriere und gelangen - wegen der Höhe der zu überwindenden Barriere - nur mit geringer Wahrscheinlichkeit in das "Floating-Gate", wodurch der Schreibprozess gebremst wird.

Das US-Patent 6,720,589 B1 beschreibt eine Speicherzelle, bei der mittels optischer Anregung eine Injektion von Elektron-Lochpaaren erfolgt.

Die Druckschriften "Tunneling emission from self-organized In(Ga)As/GaAs quantum dots observed via time-resolved capacitance measurements" (Geller et al., Physical Review, B. Condensed Matter, American Institute Of Physics, New York, Bd. 73, Nr. 20, 15.05.2006, Seite 205331-1, ISSN: 0163-1829, DOI: 10.1103/PHYSREVB. 73.205331) und "A write time of 6 ns for quantum dot-based memory structures" (Geller et al., Applied Physics Letters, Bd. 92, Nr. 9, 2008, Seite 092108) beschreiben Speicherzellen auf der Basis von Tunnelemission.

Die europäische Offenlegungsschrift EP 1 523 012 A1 offenbart eine Speicherzelle auf der Basis einer Floating-Gate Struktur.

Weitere Speicherzellen sind in den Druckschriften US 2009/0213662 A1, US 5,923,046 A1 und US 4,103,312 A1 beschrieben.

Die Druckschrift DE 10 2006 059 110 A1 offenbart ein Verfahren zum Speichern mindestens einer Bitinformation, wobei die Speicherzelle eine Halbleiterstruktur mit einem zumindest einen Potentialtopf aufweisenden Bandverlauf und zumindest zwei elektrischen Anschlüssen umfasst, wobei sich durch Anlegen einer elektrischen Einspeisespannung an die zwei Anschlüsse der Beladungszustand des Potentialtopfes mit Ladungsträgern vergrößern, durch Anlegen einer Entladespannung verkleinern und durch Anlegen einer Beibehaltespannung beibehalten lässt und wobei der jeweilige Beladungszustand des Potentialtopfes die Bitinformation der Speicherzelle festlegt.

Zusammengefasst können die aus dem Stand der Technik bekannten Speicher also in zwei Klassen eingeteilt werden, nämlich flüchtige und nichtflüchtige Speicher. Die flüchtigen Speicher haben kurze Speicherzeiten und kurze Schreib- und Löschzeiten, während die nichtflüchtigen Speicher lange Speicherzeiten, aber auch lange Schreib- und Löschzeiten aufweisen. Bislang schließen sich also lange Speicherzeiten und kurze Schreib- und Löschzeiten aus.

Der Erfindung liegt die Aufgabe zugrunde, ein Verfahren zum Speichern einer Bitinformation in einem binären Speicherbereich einer Speicherzelle anzugeben, die von ihrem Aufbau her eine relativ lange Speicherzeit und relativ schnelle Schreib- und Löschprozesse ermöglicht.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Ein wesentlicher Vorteil des erfindungsgemäßen Verfahrens besteht darin, dass dieses unipolare Ladungsträgerinjektion vorsieht und dass dieses durch den Einsatz von Ladungsträgerrekombination ein schnelles Schreiben und Löschen im Bereich von Nanosekunden ermöglicht und die Schreib- und Löschzeiten unabhängig von der Speicherzeit sind.

Ein weiterer wesentlicher Vorteil des erfindungsgemäßen Verfahrens besteht darin, dass dieses - ebenfalls wegen der Ladungsträgerrekombination - mit Schreib- und Löschspannungen von 2 Volt oder weniger auskommen kann. Geringe Schreib- und Löschspannungen vermeiden in vorteilhafter Weise Defekte in den Barrieren und erhöhen die Haltbarkeit der Speicherzelle entscheidend. Auch ist die Energieaufnahme der Speicherzelle bei geringen Schreib- und Löschspannungen klein.

Erfindungsgemäß ist die Speicherzelle derart ausgestaltet, dass ein Ändern der gespeicherten Bitinformation erfolgt, indem im Falle, dass im Speicherbereich Löcher gespeichert sind, Elektronen injiziert werden, die mit den gespeicherten Löchern rekombinieren, und die Bitinformation mit überschüssigen Elektronen überschrieben wird, und im Falle, dass im Speicherbereich Elektronen gespeichert sind, Löcher injiziert werden, die mit den gespeicherten Elektronen rekombinieren, und die Bitinformation mit überschüssigen Löchern geändert wird. Die Injektion der Löcher oder Elektronen erfolgt vorzugsweise durch Anlegen äußerer Spannungen an die Speicherzelle.

Als vorteilhaft wird es angesehen, wenn die Speicherzelle derart ausgestaltet ist, dass ein Ändern der gespeicherten Bitinformation erfolgt, indem im Falle, dass im Speicherbereich Löcher gespeichert sind, Elektronen injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum vollständigem Abbau einer (zwischen dem Speicherbereich und der Ladungsträgerinjektionsvorrichtung befindlichen) Bandverbiegung und damit der Einfangbarriere für die Elektronen führt, so dass die Elektronen direkt von der Bandkante in den Speicherbereich relaxieren und dort mit den gespeicherten Löchern rekombinieren und die Bitinformation mit überschüssigen Elektronen überschrieben wird, und im Falle, dass im Speicherbereich Elektronen gespeichert sind, zwischen Basiskontakt und dem Rücckontakt eine Löschspannung in Durchlassrichtung von mindestens der Größe der Diffusionsspannung angelegt wird, die zum Abbau der p-n-Raumladungszone führt und damit Löcher injiziert werden, die aus einem Lochreservoir der Ladungsträgerinjektionsvorrichtung in einen n-dotierten Bereich der Ladungsträgerinjektionsvorrichtung und weiter in den Speicherbereich diffundieren und/oder driften, um dort mit den gespeicherten Elektronen zu rekombinieren, und die Bitinformation mit überschüssigen Löchern geändert wird.

Alternativ kann die Anordnung der Ladungsträgerinjektionsvorrichtung auch umgekehrt sein. In diesem Falle ist die Speicherzelle vorzugsweise derart ausgestaltet, dass ein Ändern der gespeicherten Bitinformation erfolgt, indem im Falle, dass im Speicherbereich Löcher gespeichert sind, zwischen Basiskontakt und dem Rückkontakt eine Löschspannung in Durchlassrichtung von mindestens der Größe der Diffusionsspannung angelegt wird, die zum Abbau der p-n-Raumladungszone führt und damit Elektronen injiziert werden, die aus einem Elektronenreservoir der Ladungsträgerinjektionsvorrichtung in einen p-dotierten Bereich der Ladungsträgerinjektionsvorrichtung und weiter in den Speicherbereich diffundieren und/oder driften, um dort mit den gespeicherten Löchern zu rekombinieren, und die Bitinformation mit überschüssigen Elektronen geändert wird, und im Falle, dass im Speicherbereich Elektronen gespeichert sind, Löcher injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum Abbau einer (zwischen dem Speicherbereich und der Ladungsträgerinjektionsvorrichtung befindlichen) Bandverbiegung und damit der Einfangbarriere für die Löcher führt, so dass die Löcher direkt von der Bandkante in den Speicherbereich relaxieren und dort mit den gespeicherten Elektronen rekombinieren und die Bitinformation mit überschüssigen Löchern überschrieben wird.

Als besonders vorteilhaft wird es angesehen, wenn an einer Seite des Speicherbereichs die Ladungsträgerinjektionsvorrichtung mittelbar oder unmittelbar angrenzt und an der gegenüberliegenden anderen Seite eine Ausleseeinrichtung angeordnet ist, mit der sich die im Speicherbereich gespeicherte Ladungsträgerart auslesen lässt.

Um die Ladungsmenge zum Speichern der Bitinformation räumlich zu konzentrieren und lange Speicherzeiten zu erreichen, umfasst der Speicherbereich eine Doppelheterostruktur.

Vorzugsweise kann es sich dabei um eine verspannte Doppelheterostruktur handeln, die zur Ausbildung von selbstorganisierten Quantenpunkten oder Quantenringen führt.

Erfindungsgemäß weist die Ladungsträgerinjektionsvorrichtung einen p-dotierten Abschnitt und einen n-dotierten Abschnitt auf, die mittelbar oder unmittelbar an derselben Seite der Doppelheterostruktur angrenzen, so dass je nach äußerer elektrischer Ansteuerung der n-dotierte Abschnitt Elektronen oder der p-dotierte Abschnitt Löcher von derselben Seite in die Doppelheterostruktur injizieren kann.

Als vorteilhaft wird es außerdem angesehen, wenn eine Ausleseeinrichtung mit einem elektrisch leitfähigen Abschnitt vorhanden ist, dessen Leitfähigkeit von der im Speicherbereich gespeicherten Ladungsträgerart abhängt. Dies ermöglicht ein Auslesen der Bitinformation (ohne eine Veränderung der gespeicherten Bitinformation) beispielsweise durch eine Widerstands- oder Leitfähigkeitsmessung des Widerstands bzw. der Leitfähigkeit des elektrisch leitfähigen Abschnitts.

Die Ausleseeinrichtung umfasst als elektrisch leitfähigen Abschnitt vorzugsweise eine zweidimensionale Lochgasschicht oder eine zweidimensionale Elektronengasschicht.

Um kurze Lösch- und Schreibzeiten zu erreichen, wird es außerdem als vorteilhaft angesehen, wenn der Speicherbereich einen direkten Bandübergang aufweist, der beim Überschreiben der Bitinformation eine strahlende Rekombination von Elektronen und Löchern im Speicherbereich ermöglicht.

Gemäß einer ersten besonders bevorzugten Ausführungsvariante ist vorgesehen, dass der Speicherbereich undotiertes Halbleitermaterial aufweist, sich auf einer Seite des Speicherbereichs ein n-dotiertes Halbleitermaterial gefolgt von einem p-dotierten Halbleitermaterial anschließt und sich auf der anderen Seite des Speicherbereichs eine Ausleseschicht in Form einer zweidimensionalen Lochgasschicht anschließt.

Gemäß einer zweiten besonders bevorzugten Ausführungsvariante ist vorgesehen, dass der Speicherbereich undotiertes Halbleitermaterial aufweist, sich auf einer Seite des Speicherbereichs ein p-dotiertes Halbleitermaterial gefolgt von einem n-dotierten Halbleitermaterial anschließt und sich auf der anderen Seite des Speicherbereichs eine Ausleseschicht in Form einer zweidimensionalen Elektronengasschicht anschließt.

Als besonders vorteilhaft wird es angesehen, wenn an einer Seite des Speicherbereichs die Ladungsträger injiziert werden und an der gegenüberliegenden anderen Seite die im Speicherbereich gespeicherte Bitinformation - vorzugsweise durch eine Widerstands- oder Leitfähigkeitsmessung - ausgelesen wird. Vorzugsweise erfolgt ein Ändern der gespeicherten Bitinformation, indem im Falle, dass im Speicherbereich Löcher gespeichert sind, Elektronen injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum Abbau einer (zwischen dem Speicherbereich und der Ladungsträgerinjektionsvorrichtung befindlichen) Bandverbiegung und damit der Einfangbarriere für die Elektronen führt, so dass die Elektronen direkt von der Bandkante in den Speicherbereich relaxieren und dort mit den gespeicherten Löchern rekombinieren und die Bitinformation mit überschüssigen Elektronen überschrieben wird, und im Falle, dass im Speicherbereich Elektronen gespeichert sind, zwischen Basis-kontakt und dem Rückkontakt eine Löschspannung in Durchlassrichtung von mindestens der Größe der Diffusionsspannung angelegt wird, die zum Abbau der p-n-Raumladungszone führt und damit Löcher injiziert werden, die aus einem Lochreservoir der Ladungsträgerinjektionsvorrichtung in einen n-dotierten Bereich der Ladungsträgerinjektionsvorrichtung und weiter in den Speicherbereich diffundieren und/oder driften, um dort mit den gespeicherten Elektronen zu rekombinieren, und die Bitinformation mit überschüssigen Löchern geändert wird. Alternativ kann ein Ändern der gespeicherten Bitinformation erfolgen, indem im Falle, dass im Speicherbereich Löcher gespeichert sind, zwischen Basiskontakt und dem Rückkontakt eine Löschspannung in Durchlassrichtung von mindestens der Größe der Diffusionsspannung angelegt wird, die zum Abbau der p-n-Raumladungszone führt und damit Elektronen injiziert werden, die aus einem Elektronenreservoir der Ladungsträgerinjektionsvorrichtung in einen p-dotierten Bereich der Ladungsträgerinjektionsvorrichtung und weiter in den Speicherbereich diffundieren und/oder driften, um dort mit den gespeicherten Löchern zu rekombinieren, und die Bitinformation mit überschüssigen Elektronen geändert wird, und im Falle, dass im Speicherbereich Elektronen gespeichert sind, Löcher injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum Abbau einer (zwischen dem Speicherbereich und der Ladungsträgerinjektionsvorrichtung befindlichen) Bandverbiegung und damit der Einfangbarriere für die Löcher führt, so dass die Löcher direkt von der Bandkante in den Speicherbereich relaxieren und dort mit den gespeicherten Elektronen rekombinieren und die Bitinformation mit überschüssigen Löchern überschrieben wird.

Die Erfindung wird nachfolgend anhand von Ausführungsbeispielen näher erläutert, dabei zeigen beispielhaft:
- Figur 1: ein erstes Ausführungsbeispiel für eine erfindungsgemäße Speicherzelle in einer schematischen Darstellung mit einer zweidimensionalen Lochgasschicht,
- Figur 2: ein zweites Ausführungsbeispiel für eine erfindungsgemäße Speicherzelle in einer schematischen Darstellung mit einer zweidimensionalen Elektronengasschicht,
- Figur 3: ein drittes Ausführungsbeispiel für eine erfindungsgemäße Speicherzelle in einer Detaildarstellung mit einer zweidimensionalen Lochgasschicht,
- Figur 4: den berechneten Bandverlauf bei dem Ausführungsbeispiel gemäß Figur 3,
- Figur 5: den Bandverlauf und die Bandbesetzung bei dem Ausführungsbeispiel gemäß Figur 3 im Falle einer Elektronenspeicherung,
- Figur 6: den Bandverlauf und die Bandbesetzung bei dem Ausführungsbeispiel gemäß Figur 3 im Falle einer Lochspeicherung,
- Figur 7: den Bandverlauf und die Bandbesetzung bei dem Ausführungsbeispiel gemäß Figur 3 während des Löschens,
- Figur 8: den Bandverlauf und die Bandbesetzung bei dem Ausführungsbeispiel gemäß Figur 3 während des Schreibens,
- Figur 9: ein viertes Ausführungsbeispiel für eine erfindungsgemäße Speicherzelle in einer Detaildarstellung mit einer zweidimensionalen Elektronengasschicht und
- Figur 10: den berechneten Bandverlauf bei dem Ausführungsbeispiel gemäß Figur 9.

In den Figuren werden für identische oder vergleichbare Komponenten stets dieselben Bezugszeichen verwendet.

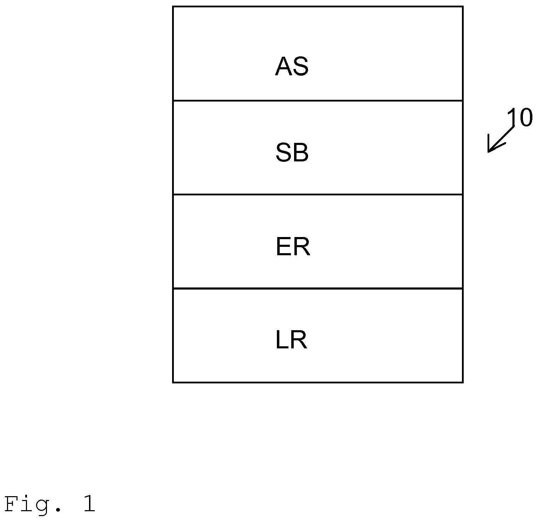

In der Figur 1 erkennt man ein erstes Ausführungsbeispiel für eine Speicherzelle 10.

Die Schichtstruktur der Speicherzelle 10 umfasst vier Halbleiterabschnitte, nämlich ein Lochreservoir LR, ein Elektronenreservoir ER, einen Speicherbereich SB und eine Ausleseschicht AS. Als Lochreservoir LR kommt vorzugsweise ein p-dotiertes Halbleitermaterial zur Anwendung und als Elektronenreservoir ER vorzugsweise ein n-dotiertes Halbleitermaterial. Das Lochreservoir LR und das Elektronenreservoir ER bilden gemeinsam eine Ladungsträgerinjektionsvorrichtung der Speicherzelle 10.

Der Speicherbereich SB umfasst vorzugsweise eine Halbleiterheterostruktur, deren Bandverlauf zumindest einen Potentialtopf aufweist. Vorzugsweise kommt eine verspannte Doppelheterostruktur zur Anwendung, die zur Bildung von zumindest einem selbstorganisierten Quantenpunkt führt[6]. Alternativ dazu kann der Speicherbereich SB aus einem oder mehreren Quantenringen oder einem Quantenfilm bestehen. Selbstorganisierte Quantenpunkte haben aber den Vorteil, dass hohe Lokalisierungsenergien selbst in stark verspannten Heterostrukturen erreicht werden[7] und dass im Vergleich zu Störstellen der Einfangquerschnitt deutlich größer ist, was zu schnellen Einfangzeiten führt [8, 9].

Die Anordnung der Schichten kann beispielsweise auf zwei verschiedene Weisen erfolgen: Das Elektronenreservoir ER kann, wie dies die Figur 1 zeigt, an den Speicherbereich SB angrenzen. In diesem Fall wird als Ausleseschicht AS vorzugsweise eine zweidimensionale Lochgasschicht eingesetzt.

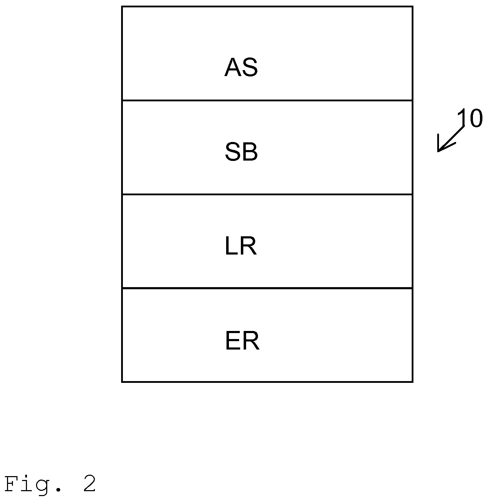

Grenzt hingegen das Lochreservoir LR, wie dies die Figur 2 zeigt, an den Speicherbereich SB an, so wird als Ausleseschicht AS vorzugsweise eine zweidimensionale Elektronengasschicht eingesetzt.

Die binären Speicherzustände der beiden in den Figuren 1 und 2 gezeigten Speicherzellen werden dadurch realisiert, dass für den einen binären Speicherzustand der Speicherbereich SB mit Elektronen besetzt wird und für den anderen binären Speicherzustand der Speicherbereich SB mit Löchern besetzt wird. Der Wechsel zwischen den beiden binären Speicherzuständen, d.h. das Schreiben bzw. das Löschen der Information, wird über eine Invertierung der Besetzung des Speicherbereichs SB von Lochspeicherung zu Elektronenspeicherung, oder umgekehrt, realisiert. Dafür wird vorzugsweise ein Spannungspuls an die Speicherzelle angelegt, die es dem zum gespeicherten Ladungsträgertyp komplementären Ladungsträgertyp ermöglicht, in den Speicherbereich SB zu gelangen und dort mit den gespeicherten Ladungsträgern vorzugsweise strahlend zu rekombinieren. Am Ende des Schreib- bzw. Löschpulses ist der anfangs gespeicherte Ladungsträgertyp aus dem Speicherbereich SB durch Rekombination entfernt worden und der Speicherbereich SB ist nun mit dem dazu komplementären Ladungsträgertyp besetzt.

Die gespeicherte Information kann beispielsweise über eine Strommessung (analog zum konventionellen Flash-Speicher) in der zum Speicherbereich SB benachbarten Ausleseschicht AS ausgelesen werden. Der Besetzungszustand des Speicherbereichs SB (Elektronen- oder Lochbesetzung) verändert nämlich aufgrund des Coulombschen Gesetzes und der Nähe der Bereiche zueinander die Leitfähigkeit der Ausleseschicht AS und kann somit über eine Strommessung leicht detektiert werden [4, 5].

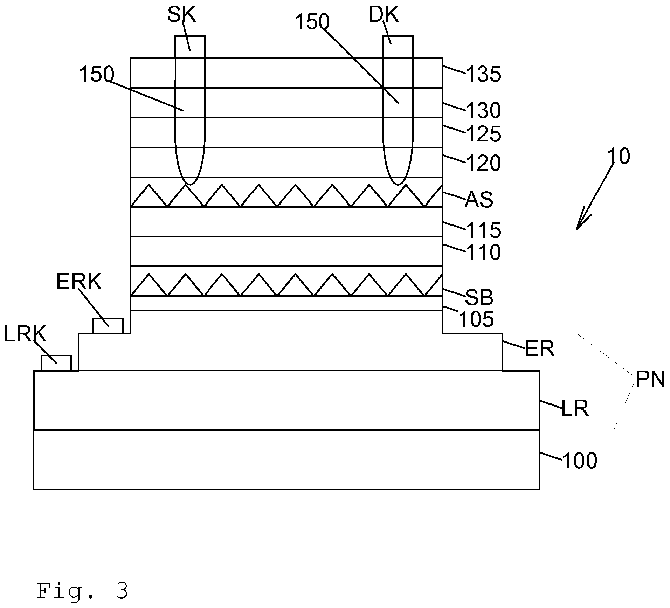

In der Figur 3 ist ein drittes Ausführungsbeispiel für eine Speicherzelle 10 gezeigt. Man erkennt ein Substrat 100, auf dem ein Lochreservoir LR in Form einer Schicht aus beispielsweise p-dotiertem GaAs (Schichtdicke vorzugsweise zwischen 100nm und 1000nm, beispielsweise 600nm; Dotierung vorzugsweise zwischen 1*10¹⁶ cm⁻³ und 1*10¹⁹ cm⁻³, beispielsweise 1*10¹⁸ cm⁻³) aufgebracht ist. Auf dem Lochreservoir LR befindet sich ein Elektronenreservoir ER in Form einer Schicht aus beispielsweise n-dotiertem GaAs (Schichtdicke vorzugsweise zwischen 100nm und 1000nm, beispielsweise 600nm; Dotierung vorzugsweise zwischen 1*10¹⁵ cm⁻³ und 1*10¹⁸ cm⁻³, beispielsweise 5*10¹⁶ cm⁻³).

Auf dem Elektronenreservoir ER ist eine Zwischenschicht 105 aus beispielsweise undotiertem GaAs angeordnet (Schichtdicke vorzugsweise zwischen 100nmm und 1000nm, beispielsweise 100nm). Die Zwischenschicht 105 trennt die durch das Lochreservoir LR und das Elektronenreservoir ER gebildete Ladungsträgerinjektionsvorrichtung in Form der pn-Diode PN von einer unteren Seite eines Speicherbereichs, der bei dem Ausführungsbeispiel gemäß Figur 3 durch eine Speicherschicht SB gebildet ist.

Die Speicherschicht SB umfasst vorzugsweise eine Quantenpunktschicht aus In(Ga)As-Quantenpunkten.

An die obere Seite der Speicherschicht SB grenzen eine Abstandsschicht 110 (Material: z. B. GaAs; Schichtdicke vorzugsweise zwischen 1nm und 10nm, beispielsweise 5nm; Dotierung vorzugsweise undotiert), eine Barriere 115 (Material: z. B. Al_{0,3}Ga_{0,7}As; Schichtdicke vorzugsweise zwischen 10nm und 100nm, beispielsweise 20nm; Dotierung vorzugsweise undotiert), sowie eine Ausleseschicht AS (z.B. Quantenfilm aus 1nm bis 10nm (z. B. 8nm) undotiertem In_{0,25}Ga_{0,75}As)an. Bei der Ausleseschicht AS handelt es sich vorzugsweise um eine zweidimensionale Lochgasschicht.

Auf der Ausleseschicht AS befinden sich vorzugsweise eine weitere Abstandsschicht 120 (Material: z. B. Al_{0,3}Ga_{0,7}As; Schichtdicke vorzugsweise zwischen 5nm und 30nm, beispielsweise 15nm; Dotierung vorzugsweise undotiert), eine dotierte Schicht 125 (Material: z. B. p-dotiertes Al_{0,3}Ga_{0,7}As; Schichtdicke vorzugsweise zwischen 0nm (δ-Dotierung) und 100nm, beispielsweise 10nm; Dotierung zwischen 1*10¹⁶ cm⁻³ und 1*10²⁰ cm^{-3,} z.B. 1*10¹⁸ cm⁻³), eine zusätzliche Abstandsschicht 130 (Material: z. B. Al_{0,3}Ga_{0,7}As; Schichtdicke vorzugsweise zwischen 1nm und 1000nm, beispielsweise 100nm; Dotierung vorzugsweise undotiert) sowie eine Deckschicht 135 (Material: z. B. undotiertes GaAs; Schichtdicke vorzugsweise zwischen 1nm und 100nm, beispielsweise 10nm).

Die Speicherzelle 10 ist mit vier Kontakten versehen, nämlich einem ohmschen Rückkontakt LRK auf dem Lochreservoir LR, einem ohmschen Basiskontakt ERK auf dem Elektronenreservoir ER sowie ohmschen Source- und Drain-Kontakten SK und DK, die die Ausleseschicht AS kontaktieren. Die Source- und Drain-Kontakte SK und DK stehen vorzugsweise über dotierte Kontaktgebiete 150 mit der vergrabenen Ausleseschicht AS in Verbindung.

Die Source- und Drain-Kontakte SK und DK, die dotierten Kontaktgebiete 150 und die vergrabene Ausleseschicht AS bilden eine Ausleseeinrichtung der Speicherzelle 10.

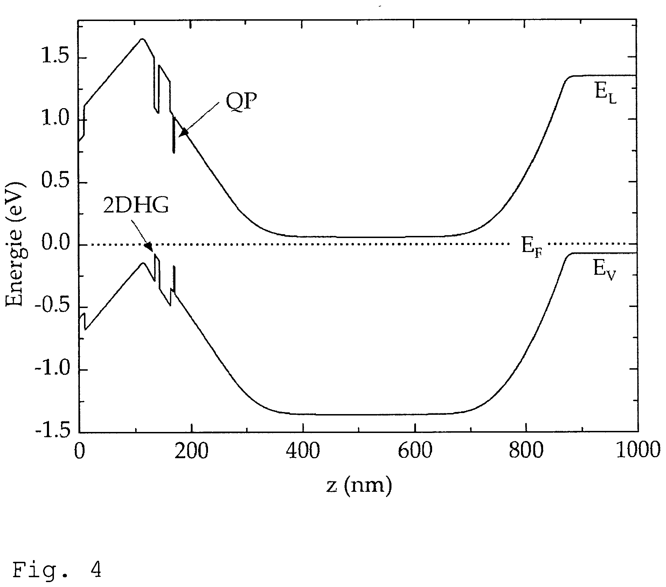

Der Bandverlauf in der Speicherzelle ohne angelegte Spannung ist beispielhaft in der Figur 4 gezeigt. Der Bandverlauf wurde mit einem sogenannten Poisson-Solver aus der Schichtstruktur berechnet. In der Figur 4 sind die Quantenpunkte mit dem Bezugszeichen QP und die zweidimensionale Lochgasschicht mit dem Bezugszeichen 2DHG bezeichnet.

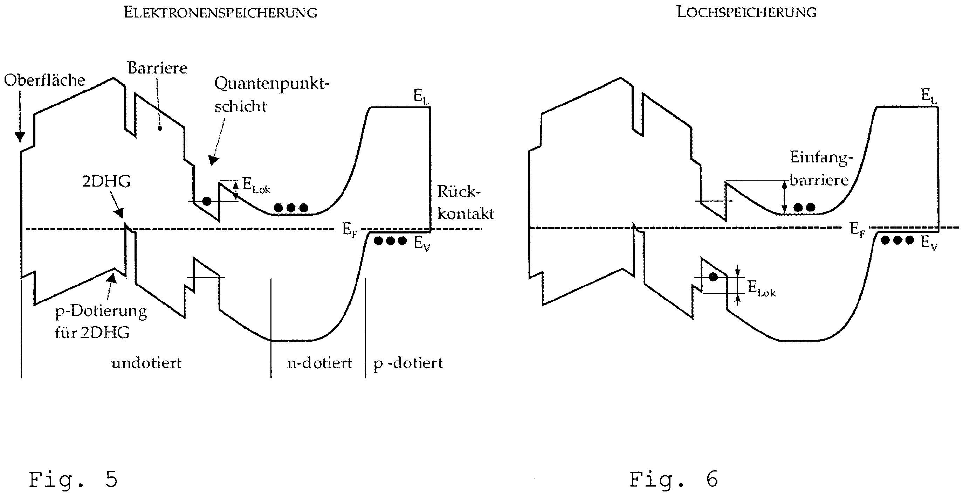

Die Speicheroperationen der Speicherzelle 10 gemäß Figur 3 werden im Folgenden näher erläutert, dabei wird auf die Figuren 5 bis 8 Bezug genommen.

### Speichervorgang:

Zum Speichern der beiden binären Speicherzustände liegt keine Spannung an der Speicherzelle an. Der Bandverlauf während der Speicherung ist für den Fall der Elektronenspeicherung in der Figur 5 und für den Fall der Lochspeicherung in der Figur 6 schematisch vereinfacht gezeigt.

Die Lokalisierungsenergie Elok der Elektronen bzw. Löcher in den Quantenpunkten der Speicherschicht SB stellt eine Emissionsbarriere für die gespeicherten Elektronen bzw. Löcher dar, die deren dauerhafte Speicherung in den Quantenpunkten gewährleistet.

Bei der Elektronenspeicherung verhindert die Bandverbiegung des n-p-Übergangs, dass Löcher vom Rückkontakt in die Quantenpunkte gelangen können und mit den gespeicherten Elektronen rekombinieren. Bei der Lochspeicherung unterdrückt die Einfangbarriere, die sich unterhalb der Quantenpunkte ausbildet, den Elektroneneinfang in die Quantenpunkte. Somit sichern Lokalisierungsenergie Elok und Einfangbarriere die dauerhafte Beibehaltung der beiden binären Zustände (Elektronen- und Lochspeicherung) ohne Zufuhr von Energie und ohne Spannung.

### Löschvorgang:

Als Löschen kann beispielsweise das Umschalten von Elektronenspeicherung zu Lochspeicherung definiert werden, jedoch ist diese Festlegung willkürlich und kann auch umgekehrt vorgenommen werden.

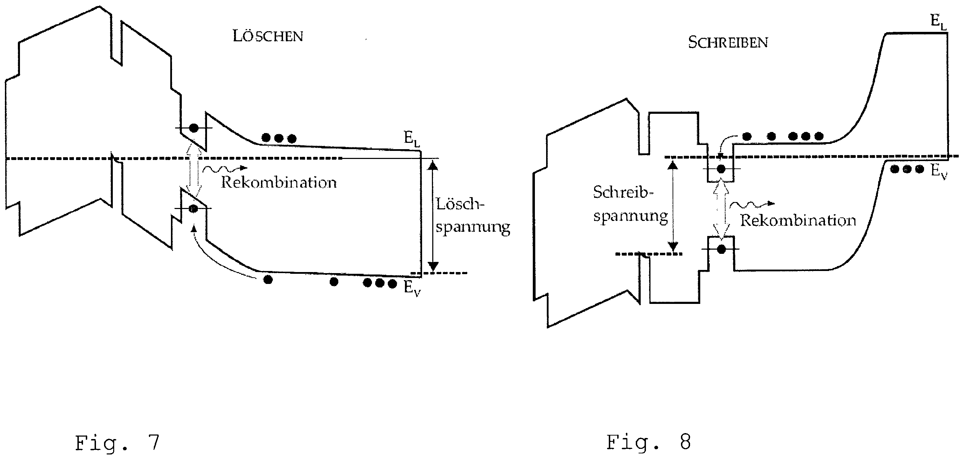

Ausgangspunkt ist beispielsweise die Elektronenspeicherung, wie sie in der Figur 5 gezeigt ist. Zwischen dem Basiskontakt und dem Rückkontakt wird eine Löschspannung in Durchlassrichtung von der Größe der Diffusionsspannung angelegt, die zum Abbau der n-p-Raumladungszone führt. Die Löcher aus dem Lochreservoir diffundieren bzw. driften in den n-dotierten Bereich und weiter in die Quantenpunkte, um dort mit den gespeicherten Elektronen zu rekombinieren (vgl. Figur 7). Zwar findet auch eine Rekombination mit den Elektronen im n-dotierten Bereich statt, jedoch ist die Schichtdicke des n-dotierten Elektronenreservoirs vorzugsweise klein gegenüber der Diffusionslänge der Löcher gewählt, so dass in diesem Bereich anteilsmäßig nur wenige Löcher rekombinieren. Die Barriere oberhalb der Quantenpunktschicht erhöht dabei den Locheinfang in die Quantenpunkte, da sie ein Hindurchdiffundieren der Löcher über die Quantenpunktschicht hinweg bis in die Ausleseschicht verhindert. Am Ende des Löschvorgangs (Löschpulses) bleiben Löcher in den Quantenpunkten als Majoritätsladung gespeichert. Die Besetzung der Quantenpunkte wurde also von Elektronen- zu Lochspeicherung invertiert (vgl. Figur 6) .

### Schreibvorgang:

Ausgangspunkt ist hier die Lochspeicherung, wie sie in der Figur 6 beispielhaft gezeigt ist. Man erkennt, dass die Quantenpunkte mit Löchern besetzt sind. Zwischen dem Source-Kontakt und dem Drain-Kontakt einerseits und dem Basis-Kontakt andererseits wird zum Schreiben eine Schreibspannung in Durchlassrichtung von der Größe der Diffusionsspannung angelegt, die zum Abbau der Bandverbiegung und damit der Einfangbarriere für die Elektronen führt. Die Elektronen relaxieren nun direkt von der Bandkante in die Quantenpunkte und rekombinieren dort mit den gespeicherten Löchern (vgl. Figur 8). Da auf Grund der Einfangbarriere zwischen Elektronenreservoir und Lochreservoir keine Löcher aus dem Lochreservoir nachfließen können, bleiben nach der Rekombination überschüssige Elektronen im Quantenpunkt gespeichert (vgl. Figur 5).

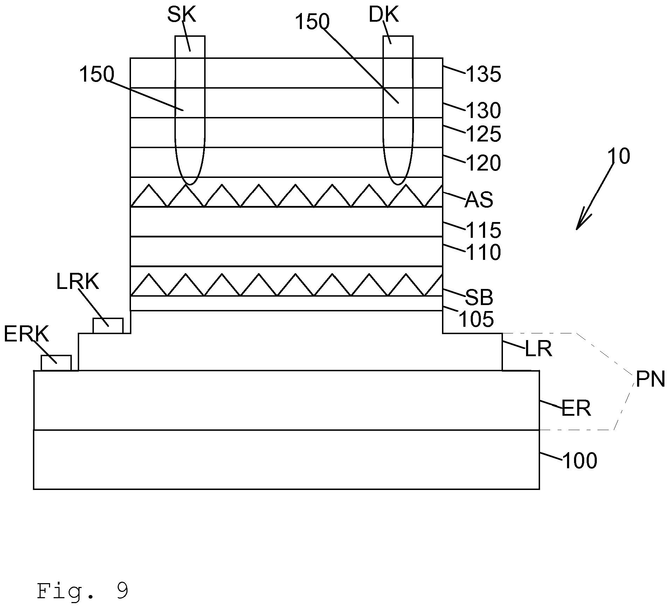

In der Figur 9 ist ein viertes Ausführungsbeispiel für eine Speicherzelle 10 gezeigt. Das vierte Ausführungsbeispiel entspricht dem dritten Ausführungsbeispiel, lediglich die Dotierung der Schichtenfolge ist invertiert, und es wird zum Auslesen eine zweidimensionale Elektronengasschicht anstelle einer zweidimensionalen Lochgasschicht eingesetzt.

Man erkennt ein Substrat 100, auf dem ein Elektronenreservoir ER in Form einer n-dotierten Schicht aufgebracht ist. Auf dem Elektronenreservoir ER befindet sich ein Lochreservoir LR in Form einer p-dotierten Schicht. Auf dem Lochreservoir LR ist eine undotierte Zwischenschicht 105 angeordnet; die Zwischenschicht trennt die durch das Lochreservoir LR und das Elektronenreservoir ER gebildete pn-Diode PN von einer unteren Seite eines Speicherbereichs in Form einer Speicherschicht SB. Die Speicherschicht SB umfasst vorzugsweise eine Quantenpunktschicht aus In(Ga)As-Quantenpunkten.

An die obere Seite der Speicherschicht SB grenzen eine undotierte Abstandsschicht 110, eine Barriere 115 sowie eine Ausleseschicht AS. Bei der Ausleseschicht AS handelt es sich vorzugsweise um eine zweidimensionale Elektronengasschicht.

Auf der Ausleseschicht AS befinden sich vorzugsweise eine weitere undotierte Abstandsschicht 120, eine n-dotierte Schicht 125, eine zusätzliche undotierte Abstandsschicht 130 sowie eine undotierte Deckschicht 135.

Die Speicherzelle 10 ist mit vier Kontakten versehen, nämlich einem ohmschen Rückkontakt ERK auf dem Elektronenreservoir ER, einem ohmschen Basiskontakt LRK auf dem Lochreservoir LR sowie ohmschen Source- und Drain-Kontakten SK und DK, die die Ausleseschicht AS kontaktieren. Die Source- und Drain-Kontakte SK und DK stehen vorzugsweise über dotierte Kontaktgebiete 150 mit der vergrabenen Ausleseschicht AS in Verbindung.

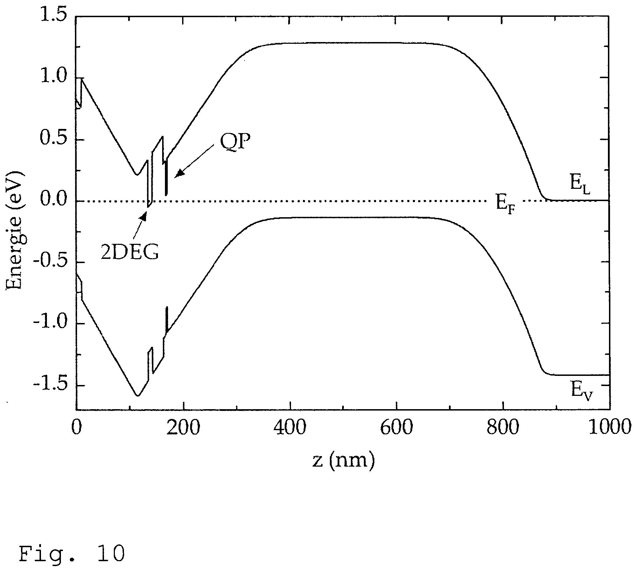

Der Bandverlauf in der Speicherzelle ohne angelegte Spannung ist beispielhaft in der Figur 10 gezeigt. Der Bandverlauf wurde mit einem sogenannten Poisson-Solver aus der Schichtstruktur berechnet. In der Figur 10 sind die Quantenpunkte mit dem Bezugszeichen QP und die zweidimensionale Elektronengasschicht mit dem Bezugszeichen 2DEG bezeichnet.

Die Speicherzellen, wie sie oben beispielhaft im Zusammenhang mit den Figuren 1-10 beschrieben worden sind, können einen oder mehrere der folgenden Vorteile aufweisen:
- Das Löschen findet durch Rekombination der Ladungsträger in der Speicherschicht statt.
- Es lassen sich unabhängig von der Speicherzeit schnelle Schreib- und Löschzeiten im Bereich der Rekombinationszeit der Ladungsträger (z. B. für Quantenpunkte im Bereich einer Nanosekunde) realisieren[10].
- Ein Kompromiss zwischen langer Speicherzeit und schneller Lösch- bzw. Schreibzeit ist nicht mehr erforderlich.
- Zum Schreiben und Löschen werden nur noch Spannungen an die Speicherzelle angelegt, die im Bereich der Diffusionsspannung der p-n-Übergänge liegen. Damit lassen sich Schreib- und Löschspannungen unter 2V realisieren, was zu einer geringen Energieaufnahme führt und im Bereich der Core-Spannung üblicher Prozessoren liegt.
- Im Gegensatz zu Flash-Speichern werden zum Schreiben und Löschen keine hohen elektrischen Felder aufgebaut, die zur bekannten geringen Haltbarkeit des Flash-Speichers führen.
- Die Haltbarkeit der hier beschriebenen Speicherzellen wird auf Grund der geringen elektrischen Felder beim Schreiben und Löschen im Bereich der Haltbarkeit üblicher DRAM-Speicher liegen.

### Literatur

[1] International Technology Roadmap for Semiconductors, Emerging Reasearch Devices, Technical report, Edition 2009.
[2] R. Waser, Nanoelectronics and Information Technology, Wiley-VCH, Berlin, 2003.
[3] P. Pavan, R. Bez, P. Olivo, and E. Zanoni, Flash memory cells - An overview, Proc. IEEE 85(8), 1248-1271 (1997).
[4] B. Marquardt, M. Geller, A. Lorke, D. Reuter, and A. D. Wieck, Using a two-dimensional electron gas to study nonequilibrium tunneling dynamics and charge storage in selfassembled quantum dots, Appl. Phys. Lett. 95(2), 022113 (2009).
[5] M. Russ, C. Meier, A. Lorke, D. Reuter, and A. D. Wieck, Role of quantum capacitance in coupled lowdimensional electron systems, Phys. Rev. B 73(11), 115334 (2006).
[6] D. Bimberg, Semiconductor Nanostructures, Springer-Verlag, Berlin Heidelberg, 2008.
[7] A. Marent, M. Geller, A. Schliwa, D. Feise, K. Pötschke, D. Bimberg, N. Akcay, and N. Oncan, 106 years extrapolated hole storage time in GaSb/AlAs quantum dots, Appl. Phys. Lett. 91(24), 242109 (2007).
[8] M. Geller, A. Marent, E. Stock, D. Bimberg, V. I. Zubkov, I. S. Shulgunova, and A. V. Solomonov, Hole capture into self-organized InGaAs quantum dots, Appl. Phys. Lett. 89(23), 232105 (2006).
[9] M. Geller, A. Marent, T. Nowozin, D. Bimberg, N. Akcay, and N. Oncan, A write time of 6 ns for quantum dot-based memory structures, Appl. Phys. Lett. 92(9), 092108 (2008) .
[10] M. Feucker, R. Seguin, S. Rodt, A. Hoffmann, and D. Bimberg, Decay dynamics of neutral and charged excitonic complexes in single InAs/GaAs quantum dots, Appl. Phys. Lett. 92(6), 063116 (2008).

### Bezugszeichenliste

- AS: Ausleseschicht
- DK: Kontakt
- E_{F}: Fermi-Energie
- E_{L}: Leitungsband
- E_{Lok}: Lokalisierungsenergie
- ER: Elektronenreservoir
- ERK: Kontakt
- E_{V}: Valenzband
- LR: Lochreservoir
- LRK: Kontakt
- PN: pn-Diode
- QP: Quantenpunkt
- SB: Speicherbereich / Speicherschicht
- SK: Kontakt
- 2DEG: zweidimensionale Elektronengasschicht
- 2DHG: zweidimensionale Lochgasschicht

- 10: Speicherzelle
- 100: Substrat
- 105: Zwischenschicht
- 110: Abstandsschicht
- 115: Barriere
- 120: Abstandsschicht
- 125: Schicht
- 130: Abstandsschicht
- 135: Deckschicht
- 150: Kontaktgebiet

## Patentansprüche

1. Verfahren zum Speichern einer Bitinformation in einem binären Speicherbereich einer Speicherzelle (10), bei der eine Ladungsträgerinjektionsvorrichtung (PN) einen p-dotierten Abschnitt (LR) und einen n-dotierten Abschnitt (ER) aufweist, wobei
- der Speicherbereich (SB) wahlweise Löcher oder Elektronen speichern kann und eine Rekombination von Löchern und Elektronen erlaubt,
- die Ladungsträgerart der in dem Speicherbereich gespeicherten Ladungsträger die Bitinformation des Speicherbereichs festlegt,
- mittels der Ladungsträgerinjektionsvorrichtung (PN) wahlweise Löcher oder Elektronen in den Speicherbereich (SB) injiziert werden können und somit die Bitinformation geändert werden kann,
- der Speicherbereich eine Doppelheterostruktur umfasst,
- der p-dotierte Abschnitt (LR) und der n-dotierte Abschnitt (ER) mittelbar oder unmittelbar an derselben Seite der Doppelheterostruktur angrenzen, sodass je nach äußerer elektrischer Ansteuerung der n-dotierte Abschnitt Elektronen oder der p-dotierte Abschnitt Löcher von derselben Seite in die Doppelheterostruktur injizieren kann,
- wobei bei dem Verfahren ein Ändern der gespeicherten Bitinformation erfolgt, indem im Falle, dass im Speicherbereich Löcher gespeichert sind, Elektronen injiziert werden, die mit den gespeicherten Löchern rekombinieren, und die Bitinformation mit überschüssigen Elektronen überschrieben wird, und im Falle, dass im Speicherbereich Elektronen gespeichert sind, Löcher injiziert werden, die mit den gespeicherten Elektronen rekombinieren, und die Bitinformation mit überschüssigen Löchern geändert wird.

2. Verfahren nach Anspruch 1, **dadurch gekennzeichnet, dass**
- ein Ändern der gespeicherten Bitinformation erfolgt, indem
- im Falle, dass im Speicherbereich Löcher gespeichert sind, Elektronen injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum Abbau einer Bandverbiegung und damit der Einfangbarriere für die Elektronen führt, so dass die Elektronen direkt von der Bandkante in den Speicherbereich relaxieren und dort mit den gespeicherten Löchern rekombinieren und die Bitinformation mit überschüssigen Elektronen überschrieben wird, und
- im Falle, dass im Speicherbereich Elektronen gespeichert sind, zwischen Basiskontakt und dem Rückkontakt eine Löschspannung in Durchlassrichtung von mindestens der Größe der Diffusionsspannung angelegt wird, die zum Abbau der p-n-Raumladungszone führt und damit Löcher injiziert werden, die aus dem p-dotierten Abschnitt der Ladungsträgerinjektionsvorrichtung in den n-dotierten Abschnitt der Ladungsträgerinjektionsvorrichtung und weiter in den Speicherbereich diffundieren und/oder driften, um dort mit den gespeicherten Elektronen zu rekombinieren, und die Bitinformation mit überschüssigen Löchern geändert wird.

3. Verfahren nach Anspruch 2,
**dadurch gekennzeichnet, dass**
- ein Ändern der gespeicherten Bitinformation erfolgt, indem
- im Falle, dass im Speicherbereich Löcher gespeichert sind, zwischen Basiskontakt und dem Rückkontakt eine Löschspannung in Durchlassrichtung von mindestens der Größe der Diffusionsspannung angelegt wird, die zum Abbau der p-n-Raumladungszone führt und damit Elektronen injiziert werden, die aus dem n-dotierten Abschnitt der Ladungsträgerinjektionsvorrichtung in den p-dotierten Abschnitt der Ladungsträgerinjektionsvorrichtung und weiter in den Speicherbereich diffundieren und/oder driften, um dort mit den gespeicherten Löchern zu rekombinieren, und die Bitinformation mit überschüssigen Elektronen geändert wird, und
- im Falle, dass im Speicherbereich Elektronen gespeichert sind, Löcher injiziert werden, indem zwischen einem Source-Kontakt und einem Drain-Kontakt der Speicherzelle einerseits und dem Basis-Kontakt der Speicherzelle andererseits zum Schreiben eine Schreibspannung in Durchlassrichtung von mindestens der Größe einer Diffusionsspannung angelegt wird, die zum Abbau einer Bandverbiegung und damit der Einfangbarriere für die Löcher führt, so dass die Löcher direkt von der Bandkante in den Speicherbereich relaxieren und dort mit den gespeicherten Elektronen rekombinieren und die Bitinformation mit überschüssigen Löchern überschrieben wird.

4. Verfahren nach Anspruch 1,
**dadurch gekennzeichnet, dass**
- an einer Seite des Speicherbereichs die Ladungsträgerinjektionsvorrichtung (PN) mittelbar oder unmittelbar angrenzt und
- an der gegenüberliegenden anderen Seite eine Ausleseeinrichtung angeordnet ist, mit der sich die im Speicherbereich gespeicherte Ladungsträgerart auslesen lässt.

5. Verfahren nach Anspruch 4,
**dadurch gekennzeichnet, dass**
die Ausleseeinrichtung mit einem elektrisch leitfähigen Abschnitt (AS) vorhanden ist, dessen Leitfähigkeit von der im Speicherbereich gespeicherten Ladungsträgerart abhängt.

6. Verfahren nach einem der voranstehenden Ansprüche 4-5,
**dadurch gekennzeichnet, dass**
die Ausleseeinrichtung eine zweidimensionale Lochgasschicht (2DHG) oder eine zweidimensionale Elektronengasschicht (2DEG) umfasst.

7. Verfahren nach einem der voranstehenden Ansprüche,
**dadurch gekennzeichnet, dass**
der Speicherbereich einen direkten Bandübergang aufweist, der beim Überschreiben der Bitinformation eine strahlende Rekombination von Elektronen und Löchern ermöglicht.

8. Verfahren nach einem der voranstehenden Ansprüche,
**dadurch gekennzeichnet, dass**
- der Speicherbereich (SB) undotiertes Halbleitermaterial aufweist, sich auf einer Seite des Speicherbereichs das n-dotierte Halbleitermaterial (ER) gefolgt von dem p-dotierten Halbleitermaterial (LR) anschließt und sich auf der anderen Seite des Speicherbereichs als Ausleseeinrichtung eine Ausleseschicht (AS) in Form einer zweidimensionalen Lochgasschicht (2DHG) anschließt, oder
- der Speicherbereich (SB) undotiertes Halbleitermaterial aufweist, sich auf einer Seite des Speicherbereichs das p-dotierte Halbleitermaterial (LR) gefolgt von dem n-dotierten Halbleitermaterial (ER) anschließt und sich auf der anderen Seite des Speicherbereichs (SB) eine Ausleseschicht (AS) in Form einer zweidimensionalen Elektronengasschicht (2DEG) anschließt.

9. Verfahren nach einem der voranstehenden Ansprüche,
**dadurch gekennzeichnet, dass**
der Speicherbereich (SB) eine Quantenpunktschicht aus In(Ga)As-Quantenpunkten umfasst.

10. Verfahren nach einem der voranstehenden Ansprüche 1 bis 8,
**dadurch gekennzeichnet, dass**
der Speicherbereich (SB) aus einem oder mehreren Quantenringen oder einem Quantenfilm besteht.

11. Verfahren nach einem der voranstehenden Ansprüche 1 bis 8,
**dadurch gekennzeichnet, dass**
die Doppelheterostruktur eine verspannte Doppelheterostruktur ist, die zur Ausbildung von selbstorganisierten Quantenpunkten oder Quantenringen führt.

## Claims

1. Method for storing bit information in a binary memory area of a memory cell (10) in which a charge carrier injection device (PN) has a p-doped section (LR) and an n-doped section (ER), wherein
- the memory area (SB) can optionally store holes or electrons and allows a recombination of holes and electrons,
- the charge carrier type of the charge carriers stored in the memory area defines the bit information of the memory area,
- by means of the charge carrier injection device (PN) optionally holes or electrons can be injected into the memory area (SB) and the bit information can thus be changed,
- the memory area comprises a double heterostructure,
- the p-doped section (LR) and the n-doped section (ER) indirectly or directly adjoin the same side of the double-heterostructure, such that, depending on external electrical driving, the n-doped section can inject electrons or the p-doped section can inject holes from the same side into the double heterostructure,
- wherein in the method the stored bit information is changed by virtue of the fact that in the case where holes are stored in the memory area, electrons are injected, which recombine with the stored holes, and the bit information is overwritten with excess electrons, and in the case where electrons are stored in the memory area, holes are injected, which recombine with the stored electrons, and the bit information is changed with excess holes.

2. Method according to Claim 1,
**characterized in that**
- the stored bit information is changed by virtue of the fact that
- in the case where holes are stored in the memory area, electrons are injected by virtue of the fact that between a source contact and a drain contact of the memory cell, on the one hand, and the base contact of the memory cell, on the other hand, for writing purposes a write voltage in the forward direction of at least the magnitude of a diffusion voltage is applied, which leads to the reduction of a band bending and thus of the trapping barrier for the electrons, such that the electrons relax directly from the band edge into the memory area and recombine there with the stored holes and the bit information is overwritten with excess electrons, and
- in the case where electrons are stored in the memory area, between the base contact and the rear contact an erase voltage in the forward direction of at least the magnitude of the diffusion voltage is applied, which leads to the reduction of the p-n space charge zone and holes are thus injected, which diffuse and/or drift from the p-doped section of the charge carrier injection device into an n-doped section of the charge carrier injection device and further into the memory area in order to recombine there with the stored electrons, and the bit information is changed with excess holes.

3. Method according to Claim 2,
**characterized in that**
- the stored bit information is changed by virtue of the fact that
- in the case where holes are stored in the memory area, between the base contact and the rear contact an erase voltage in the forward direction of at least the magnitude of the diffusion voltage is applied, which leads to the reduction of the p-n space charge zone and electrons are thus injected, which diffuse and/or drift from the n-doped section of the charge carrier injection device into the p-doped section of the charge carrier injection device and further into the memory area in order to recombine there with the stored holes, and the bit information is changed with excess electrons, and
- in the case where electrons are stored in the memory area, holes are injected by virtue of the fact that between a source contact and a drain contact of the memory cell, on the one hand, and the base contact of the memory cell, on the other hand, for writing purposes a write voltage in the forward direction of at least the magnitude of a diffusion voltage is applied, which leads to the reduction of a band bending and thus of the trapping barrier for the holes, such that the holes relax directly from the band edge into the memory area and recombine there with the stored electrons and the bit information is overwritten with excess holes.

4. Method according to Claim 1,
**characterized in that**
- the charge carrier injection device (PN) indirectly or directly adjoins one side of the memory area, and
- a read-out device is arranged at the opposite other side, by means of which read-out device the charge carrier type stored in the memory area can be read out.

5. Method according to Claim 4,
**characterized in that**
the read-out device having an electrically conductive section (AS) is present, the conductivity of said section depending on the charge carrier type stored in the memory area.

6. Method according to any of the preceding Claims 4-5,
**characterized in that**
the read-out device comprises a two-dimensional hole gas layer (2DHG) or a two-dimensional electron gas layer (2DEG).

7. Method according to any of the preceding claims,
**characterized in that**
the memory area has a direct band transition which enables a radiative recombination of electrons and holes during the overwriting of the bit information.

8. Method according to any of the preceding claims,
**characterized in that**
- the memory area (SB) comprises undoped semiconductor material, on one side of the memory area there is adjacent the n-doped semiconductor material (ER) followed by the p-doped semiconductor material (LR), and on the other side of the memory area there is adjacent a read-out layer (AS) in the form of a two-dimensional hole gas layer (2DHG) as a read-out device, or
- the memory area (SB) comprises undoped semiconductor material, on one side of the memory area there is adjacent the p-doped semiconductor material (LR) followed by the n-doped semiconductor material (ER), and on the other side of the memory area (SB) there is adjacent a read-out layer (AS) in the form of a two-dimensional electron gas layer (2DEG).

9. Method according to any of the preceding claims,
**characterized in that**
the memory area (SB) comprises a quantum dot layer composed of In(Ga)As quantum dots.

10. Method according to any of the preceding Claims 1 to 8,
**characterized in that**
the memory area (SB) consists of one or more quantum rings or a quantum film.

11. Method according to any of the preceding Claims 1 to 8,
**characterized in that**
the double heterostructure is a strained double heterostructure which leads to the formation of self-assembled quantum dots or quantum rings.

## Revendications

1. Procédé permettant d'enregistrer une information binaire dans une zone de mémoire binaire d'une cellule de mémoire (10) dans laquelle un dispositif d'injection de porteur de charge (PN) présente une partie dopée p (LR) et une partie dopée n (ER), dans lequel
- la zone de mémoire (SB) peut enregistrer au choix des trous ou des électrons et permet une recombinaison de trous et d'électrons,
- le type de porteur de charge des porteurs de charge enregistrés dans la zone de mémoire détermine l'information binaire de la zone de mémoire,
- le dispositif d'injection de porteur de charge (PN) permet au choix d'injecter des trous ou des électrons dans la zone de mémoire (SB) et de modifier ainsi l'information binaire,
- la zone de mémoire comprend une hétérostructure double,
- la partie dopée p (LR) et la partie dopée n (ER) sont indirectement ou directement adjacentes au même côté de l'hétérostructure double de sorte qu'en fonction d'une excitation électrique externe la partie dopée n peut injecter des électrons ou la partie dopée p peut injecter des trous à partir du même côté dans l'hétérostructure double,
- dans lequel, dans le procédé, une modification de l'information binaire enregistrée a lieu en ce que dans le cas où des trous seraient enregistrés dans la zone de mémoire, des électrons sont injectés qui se recombinent avec les trous enregistrés, et l'information binaire est écrasée par des électrons excédentaires, et dans le cas où dans la zone de mémoire des électrons seraient enregistrés, des trous sont injectés qui se recombinent avec les électrons enregistrés, et l'information binaire est modifiée par des trous excédentaires.

2. Procédé selon la revendication 1, **caractérisé en ce que**
- une modification de l'information binaire enregistrée a lieu **en ce que**
- dans le cas où dans la zone de mémoire des trous seraient enregistrés, des électrons sont injectés **en ce qu'**entre un contact de source et un contact de drain de la cellule de mémoire d'une part et le contact de base de la cellule de mémoire d'autre part, pour l'écriture une tension d'écriture au moins de l'ordre d'une tension de diffusion est appliquée dans le sens passant et entraîne une diminution d'une déformation de bande et donc de la barrière de capture de sorte que les électrons s'évacuent directement du bord de bande dans la zone de mémoire et s'y recombinent avec les trous enregistrés, et l'information binaire est écrasée par des électrons excédentaires, et
- dans le cas où dans la zone de mémoire des électrons seraient enregistrés, entre le contact de base et le contact de retour, une tension d'extinction dans le sens passant au moins de l'ordre de la tension de diffusion est appliquée et entraîne la diminution de la zone de charge spatiale p-n, et des trous sont donc injectés qui se diffusent et/ou dérivent à partir de la partie dopée p du dispositif d'injection de porteur de charge dans la partie dopée n du dispositif d'injection de porteur de charge et ensuite dans la zone de mémoire afin de s'y recombiner avec les électrons enregistrés, et l'information binaire est modifiée par des trous excédentaires.

3. Procédé selon la revendication 2, **caractérisé en ce que**
- une modification de l'information binaire enregistrée a lieu **en ce que**
- dans le cas où dans la zone de mémoire des trous seraient enregistrés, entre le contact de base et le contact de retour, une tension d'extinction dans le sens passant au moins de l'ordre de la tension de diffusion est appliquée et entraîne la diminution de la zone de charge spatiale p-n, et des électrons sont donc injectés qui se diffusent et/ou dérivent à partir de la partie dopée n du dispositif d'injection de porteur de charge dans la partie dopée p du dispositif d'injection de porteur de charge et ensuite dans la zone de mémoire afin de s'y recombiner avec les trous enregistrés, et l'information binaire est modifiée par des électrons excédentaires, et
- dans le cas où dans la zone de mémoire des électrons seraient enregistrés, des trous sont injectés **en ce qu'**entre un contact de source et un contact de drain de la cellule de mémoire d'une part et le contact de base de la cellule de mémoire d'autre part, pour l'écriture une tension d'écriture dans le sens passant au moins de l'ordre d'une tension de diffusion est appliquée et entraîne la diminution d'une déformation de bande et donc de la barrière de capture pour les trous de sorte que les trous s'évacuent directement du bord de bande dans la zone de mémoire et s'y recombinent avec les électrons enregistrés, et l'information binaire est écrasée par des trous excédentaires.

4. Procédé selon la revendication 1, **caractérisé en ce que**
- sur un côté de la zone de mémoire, le dispositif d'injection de porteur de charge (PN) est indirectement ou directement adjacent, et
- sur l'autre côté opposé, un dispositif de lecture est disposé qui permet de lire le type de porteur de charge enregistré dans la zone de mémoire.

5. Procédé selon la revendication 4, **caractérisé en ce que** le dispositif de lecture est présent avec une partie électriquement conductrice (AS) dont la conductibilité dépend du type de porteur de charge enregistré dans la zone de mémoire.

6. Procédé selon l'une quelconque des revendications précédentes 4 à 5, **caractérisé en ce que** le dispositif de lecture comprend une couche de gaz de trous bidimensionnel (2DHG) ou une couche de gaz d'électrons bidimensionnel (2DEG).

7. Procédé selon l'une quelconque des revendications précédentes, **caractérisé en ce que** la zone de mémoire présente un passage de bande qui permet à l'écrasement de l'information binaire une recombinaison rayonnante des électrons et des trous.

8. Procédé selon l'une quelconque des revendications précédentes, **caractérisé en ce que**
- la zone de mémoire (SB) présente un matériau semi-conducteur non dopé, sur un côté de la zone de mémoire le matériau semi-conducteur dopé n (ER) suivi du matériau semi-conducteur dopé p (LR) est adjacent, et sur l'autre côté de la zone de mémoire une couche de lecture (AS) sous la forme d'une couche de gaz de trous bidimensionnel (2DHG) est adjacente comme dispositif de lecture, ou
- la zone de mémoire (SB) présente du matériau semi-conducteur non dopé, sur un côté de la zone de mémoire le matériau semi-conducteur dopé p (LR) suivi du matériau semi-conducteur dopé n (ER) est adjacent, et sur l'autre côté de la zone de mémoire (SB) une couche de lecture (AS) sous la forme d'une couche de gaz d'électrons bidimensionnel (2DEG) est adjacente.

9. Procédé selon l'une quelconque des revendications précédentes, **caractérisé en ce que** la zone de mémoire (SB) comprend une couche de points quantiques composée de points quantiques In(Ga)As.

10. Procédé selon l'une quelconque des revendications précédentes 1 à 8, **caractérisé en ce que** la zone de mémoire (SB) est composée d'un ou de plusieurs anneaux quantiques ou d'un puits quantique.

11. Procédé selon l'une quelconque des revendications précédentes 1 à 8, **caractérisé en ce que** l'hétérostructure double est une hétérostructure double sous contrainte qui entraîne la formation de points quantiques ou d'anneaux quantiques auto-organisés.
